# EUROPÄISCHE PATENTSCHRIFT

(11) **EP 2 727 242 B1**
(45) Veröffentlichungstag und Bekanntmachung des Hinweises auf die Patenterteilung: **10.06.2015**
(21) Anmeldenummer: 12728580.7
(22) Anmeldetag: 20.06.2012
(51) Int. Cl.: H03K 17/725, H03K 17/73

(54) **HAUSHALTSGERÄT MIT EINER NETZSCHALTEREINRICHTUNG UND VERFAHREN ZUM VERSORGEN EINES ELEKTRISCHEN VERBRAUCHERS EINES HAUSHALTSGERÄTES ÜBER EINE NETZSCHALTEREINRICHTUNG**
DOMESTIC APPLIANCE AND METHOD FOR SUPPLYING ELECTRICAL ENERGY TO AN ELECTRICAL LOAD
APPAREIL MÉNAGER ET PROCÉDÉ D'ALIMENTATION D'UN CONSOMMATEUR ÉLECTRIQUE EN ÉNERGIE ÉLECTRIQUE

(30) Priorität: 30.06.2011 DE 102011078463
(43) Veröffentlichungstag der Anmeldung: 07.05.2014
(73) Patentinhaber: BSH Hausgeräte GmbH, 81739 München (DE)
(72) Erfinder: BRUSS, Dietmar, 93173 Wenzenbach (DE); FELDMEIER, Rudolf, 93128 Regenstauf / Eitlbrunn (DE)
(86) Internationale Anmeldenummer: PCT/EP2012/061854
(87) Internationale Veröffentlichungsnummer: WO 2013/000794

(56) Entgegenhaltungen:
- US-A- 4 329 630
- US-A- 4 412 160

## Beschreibung

Die Erfindung betrifft ein Haushaltsgerät, welches einen ersten und einen zweiten elektrischen Anschluss aufweist, zwischen denen eine elektrische Netzspannung (Wechselspannung) angelegt werden kann. Das Haushaltsgerät beinhaltet auch einen elektrischen Verbraucher sowie eine Netzschaltereinrichtung, über welche der elektrische Verbraucher mit den Anschlüssen koppelbar ist. Die Erfindung betrifft außerdem ein Verfahren zum Versorgen eines elektrischen Verbrauchers eines Haushaltsgeräts mit elektrischer Energie.

Es geht vorliegend um die Ausgestaltung der Netzschaltereinrichtung, über welche der elektrische Verbraucher mit den elektrischen Anschlüssen des Haushaltsgeräts gekoppelt wird. Eine solche Netzschaltereinrichtung muss zum Betrieb mit einem elektrischen Strom hoher Stromstärke ausgelegt sein, etwa mit einem Strom von 16 A. Die WO 2011138119 zeigt ein solches Gerät. Es werden bisher mechanische Netzschalter eingesetzt, die nicht ganz unproblematisch sind: Nachteile eines mechanischen Netzschalters - zum Beispiel eines Relais - liegen oft im Verschleiß, in der Baugröße und somit auch Designproblemen, wie auch in der elektromagnetischen Verträglichkeit (EMV) aufgrund eines "Prellens" der Kontaktelemente.

US 4,329,630 zeigt eine PCM-Ansteuerung für einen DC-Motor einer Waschmaschine mit einer Polaritätswechselschaltung. Die Polaritätswechselschaltung besteht aus einer Thyristor-Brückenschaltung, bei der zur Steuerung der Drehrichtung des Motors Thyristoren paarweise durchgeschaltet werden.

US 4,412,160 zeigt eine weitere Ansteuerungsschaltung für einen DC-Motor mit einer Polaritätswechselschaltung. Die Polaritätswechselschaltung ist in Form einer Doppel-Brückenschaltung mit antiparallel geschalteten Thyristoren ausgebindet. Zur Steuerung der Drehrichtung des Motors wird in jedem Brückenzweig einer der antiparallel geschalteten Thyristoren durchgeschaltet.

Es ist Aufgabe der Erfindung, einen Weg aufzuzeigen, wie bei einem Haushaltsgerät der eingangs genannten Gattung die Nachteile des Standes der Technik ohne viel Aufwand umgangen werden können.

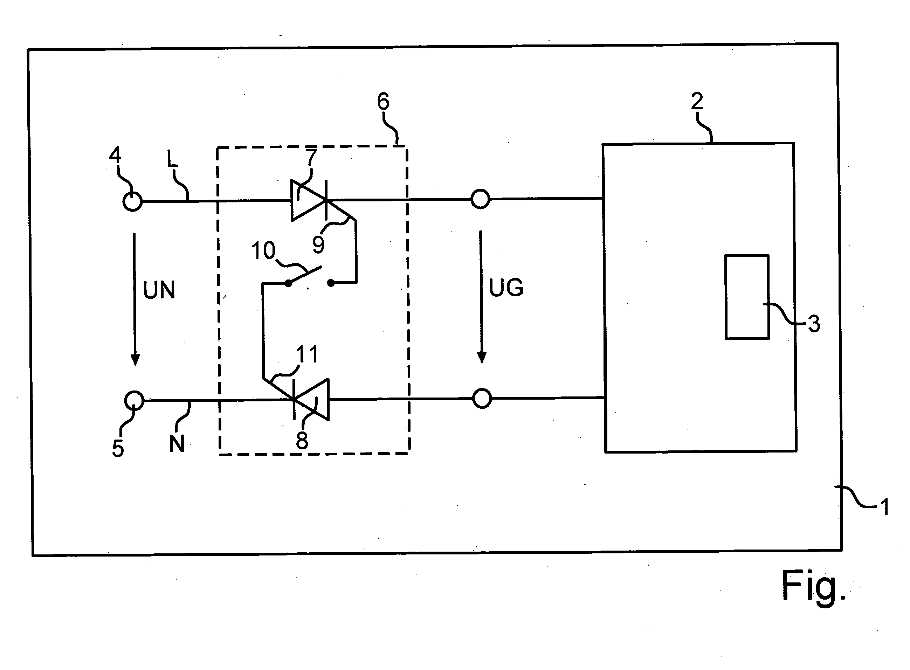

Diese Aufgabe wird erfindungsgemäß durch ein Haushaltsgerät sowie durch ein Verfahren mit den Merkmalen gemäß den jeweiligen unabhängigen Patentansprüchen gelöst. Vorteilhafte Ausführungen der Erfindung sind Gegenstand der abhängigen Patentansprüche, der Beschreibung und der Figur.

Ein erfindungsgemäßes Haushaltsgerät umfasst einen ersten und einen zweiten elektrischen Anschluss, zwischen denen eine elektrische Netzspannung angelegt werden kann. Das Haushaltsgerät weist auch einen elektrischen Verbraucher auf, wie auch eine Netzschaltereinrichtung, über welche der elektrische Verbraucher mit den Anschlüssen gekoppelt werden kann. Erfindungsgemäß beinhaltet die Netzschaltereinrichtung folgende Komponenten: Einen zwischen dem ersten Anschluss und dem elektrischen Verbraucher geschalteten ersten Thyristor, dessen Anode mit dem ersten Anschluss und dessen Kathode mit dem elektrischen Verbraucher gekoppelt sind; einen zwischen dem zweiten Anschluss und dem elektrischen Verbraucher geschalteten zweiten Thyristor, dessen Anode mit dem elektrischen Verbraucher und dessen Kathode mit dem zweiten Anschluss gekoppelt sind; sowie eine Zündeinrichtung zum Zünden der Thyristoren, wobei die Zündeinrichtung einen für die beiden Thyristoren gemeinsamen elektrischen Schalter aufweist, über welchen ein Gate-Anschluss des ersten Thyristors und ein Gate-Anschluss des zweiten Thyristors mit einem elektrischen Zündstrom beaufschlagbar sind

Anders als im Stand der Technik werden somit zum Koppeln des elektrischen Verbrauchers mit den elektrischen Anschlüssen des Haushaltsgeräts nicht mechanische Netzschalter, sondern Halbleiterschalter eingesetzt, und zwar ganz spezifische Halbleiterschalter, nämlich Thyristoren. Eine derartige Ausgestaltung der Netzschaltereinrichtung hat folgende Vorteile: Es tritt insbesondere kein "Prellen" von Kontaktelementen auf, so daß auch keine EMV-Probleme auftreten. Außerdem ist der mechanische Verschleiß nicht mehr vorhanden, und es kann eine höhere Lebensdauer der Netzschaltereinrichtung erreicht werden. Diese Lebensdauer hängt nun von der Dimensionierung der Thyristoren ab. Aufgrund einer möglichen geringeren Baugröße der Thyristoren ergeben sich außerdem Vorteile im Hinblick auf das Design beziehungsweise die Ausgestaltung der gesamten Anordnung einschließlich des Verbrauchers, der Netzschaltereinrichtung und der Anschlüsse. Das erfindungsgemäße Haushaltsgerät hat außerdem den Vorteil, daß die Netzschaltereinrichtung im Prinzip zwei verschiedene Funktionen erfüllt. Neben der Funktion des Koppelns des Verbrauchers mit den Anschlüssen dient die Netzschaltereinrichtung mit den Thyristoren auch als Gleichrichter, mittels welchem die elektrische Netzspannung gleichgerichtet wird. Es erübrigt sich somit der Einsatz eines zusätzlichen Gleichrichters mit den damit verbunden Nachteilen hinsichtlich des Bauraums und der Kosten. Der Netzschaltereinrichtung kann beispielsweise ein einfaches Netzteil mit einem Kondensator - zum Beispiel einem Zwischenkreiskondensator - nachgeschaltet werden.

Unter einem Haushaltsgerät wird vorliegend ein Gerät verstanden, welches zur Haushaltsführung eingesetzt wird und somit zur Behandlung von Haushaltsgegenständen ausgebildet ist. Das kann ein Haushaltsgroßgerät sein, wie beispielsweise eine Waschmaschine, ein Wäschetrockner, eine Geschirrspülmaschine, ein Gargerät, eine Dunstabzugshaube, ein Kältegerät, eine Kühlgefrierkombination oder ein Klimagerät. Das kann aber auch ein Haushaltskleingerät sein, wie beispielsweise ein Kaffeevollautomat oder eine Küchenmaschine.

Unter einem Thyristor versteht man ein steuerbares beziehungsweise ein schaltbares Halbleiterbauelement, welches in einem Ausgangszustand elektrisch nicht leitend ist beziehungsweise sperrt und durch einen elektrischen Strom (Gatestrom bzw. Zündstrom) geringer Stromstärke eingeschaltet beziehungsweise leitend geschaltet werden kann. Nach dem Einschalten bleibt der Thyristor auch ohne den Gatestrom leitend und wird durch eine Umkehrung der Stromrichtung ausgeschaltet.

Erfindungsgemäß weist die Zündeinrichtung einen für die beiden Thyristoren gemeinsamen elektrischen Schalter auf, über welchen ein Gate-Anschluss des ersten Thyristors sowie ein Gate-Anschluss des zweiten Thyristors mit einem elektrischen Zündstrom beziehungsweise Gatestrom beaufschlagbar sind. Die Zündeinrichtung kommt somit mit lediglich einem Schalter aus, so daß sich der Einsatz eines separaten Schalters erübrigt. Hierdurch können die Kosten sowie der wertvolle Bauraum gespart werden.

Erfindungsgemäß wird über den Schalter der Gate-Anschluss des ersten Thyristors mit dem Gate-Anschluss des zweiten Thyristors elektrisch verbunden. In einem elektrisch leitenden Schaltzustand des Schalters sind somit die Gate-Anschlüsse elektrisch leitfähig miteinander verbunden; in einem elektrisch sperrenden Schaltzustand des Schalters sind sie elektrisch voneinander getrennt. Es hat sich nämlich herausgestellt, daß bei einer solchen Anordnung des Schalters zwischen den Gate-Anschlüssen in seinem elektrisch leitenden Schaltzustand - wenn die beiden Gate-Anschlüsse elektrisch leitfähig miteinander verbunden sind - die beiden Thyristoren mit einem elektrischen Leckstrom als Zündstrom gezündet werden. Verbindet man also die beiden Gate-Anschlüsse miteinander, so fließt über die jeweiligen Gate-Strecken ein Leckstrom, welcher ein Zünden der beiden Thyristoren bewirkt beziehungsweise als Zündstrom wirkt. Die Ansteuerung der Netzschaltereinrichtung vereinfacht sich somit erheblich: Es braucht lediglich der elektrische Schalter zwischen den Gate-Anschlüssen geschlossen werden, und die beiden Thyristoren werden quasi automatisch gezündet und eingeschaltet. Bleibt der elektrische Schalter während des Betriebs des elektrischen Verbrauchers geschlossen, so werden die Thyristoren - synchron mit der Netzspannung - fortlaufend ein- und wieder ausgeschaltet, so daß die Netzspannung gleichgerichtet wird. Es brauchen also keine Stromimpulse zum Zünden der Thyristoren aktiv erzeugt werden; die Ansteuerung der Netzschaltereinrichtung reduziert sich zum Schließen beziehungsweise Öffnen des elektrischen Schalters. Außerdem kann dieser Schalter relativ klein dimensioniert werden, weil der Zündstrom beziehungsweise Leckstrom eine sehr geringe Stromstärke aufweist, nämlich einige µA.

Bevorzugt ist der elektrische Schalter ein mechanischer Schalter, insbesondere ein Relais. Auf diese Weise wird verhindert, daß im elektrisch sperrenden Schaltzustand des Schalters ein elektrischer Leckstrom über den Schalter fließt und gegebenenfalls ein ungewolltes Zünden der Thyristoren bewirkt.

Ein erfindungsgemäßes Verfahren ist zum Versorgen eines elektrischen Verbrauchers eines Haushaltsgeräts mit elektrischer Energie ausgelegt, wobei der elektrische Verbraucher über eine Netzschaltereinrichtung mit einem ersten und einem zweiten elektrischen Anschluss des Haushaltsgeräts gekoppelt wird, zwischen denen eine elektrische Netzspannung angelegt wird. Der elektrische Verbraucher wird über einen ersten Thyristor der Netzschaltereinrichtung mit dem ersten Anschluss sowie über einen zweiten Thyristor der Netzschaltereinrichtung mit dem zweiten Anschluss gekoppelt, und die Thyristoren werden mittels einer Zündeinrichtung gezündet, wobei ein Gate-Anschluss des ersten Thyristors und ein Gate-Anschluss des zweiten Thyristors über einen gemeinsamen elektrischen Schalter der Zündeinrichtung mit einem elektrischen Zündstrom beaufschlagt werden.

Die mit Bezug auf das erfindungsgemäße Haushaltsgerät vorgestellten bevorzugten Ausführungsformen und deren Vorteile gelten entsprechend für das erfindungsgemäße Verfahren.

Weitere Merkmale der Erfindung ergeben sich aus den Ansprüchen, der Figur und der Figurenbeschreibung. Alle vorstehend in der Beschreibung genannten Merkmale und Merkmalskombinationen sowie die nachfolgend in der Figurenbeschreibung genannten und/oder in der Figur alleine gezeigten Merkmale und Merkmalskombinationen sind nicht nur in der jeweils angegebenen Kombination, sondern auch in anderen Kombinationen oder aber in Alleinstellung verwendbar.

Die Erfindung wird nun anhand eines bevorzugten Ausführungsbeispiels näher erläutert, wie auch unter Bezugnahme auf die beigefügte Zeichnung. Dabei veranschaulicht die einzige Figur in schematischer Darstellung ein Haushaltsgerät gemäß einer Ausführungsform der Erfindung.

In einem Haushaltsgerät 1 befindet sich eine Verbraucherschaltung 2 mit einem elektrischen Verbraucher 3. Der Verbraucher 3 kann ein beliebiger Verbraucher sein, etwa ein Antriebsmotor, ein elektrischer Widerstand oder dergleichen. Insbesondere ist der Verbraucher 3 nicht auf eine konkrete Art - etwa kapazitiv oder induktiv - beschränkt. Die Verbraucherschaltung 2 kann auch ein Netzteil beinhalten, welches einen Kondensator umfasst, an welchem der Verbraucher 3 eine Versorgungsspannüng abgreift.

Das Haushaltsgerät 1 weist auch zwei elektrische Anschlüsse auf, nämlich einen ersten Anschluss 4 sowie einen zweiten Anschluss 5. Zwischen den Anschlüssen 4, 5 kann eine elektrische Netzspannung UN angelegt werden, nämlich wenn die Anschlüsse 4, 5 mit einem elektrischen Versorgungsnetz beziehungsweise Stromnetz verbunden werden. Der erste Anschluss 4 ist mit einem Phasenleiter L verbunden, währen der zweite Anschluss 5 mit einem Neutralleiter N (Nullleiter) verbunden ist. Zwischen den Anschlüssen 4, 5 einerseits und der Verbraucherschaltung 2 andererseits ist eine Netzschaltereinrichtung 6 geschaltet, über welche die Verbraucherschaltung 2 mit den Anschlüssen 4, 5 elektrisch verbunden werden kann. Die Netzschaltereinrichtung 6 beinhaltet einen ersten Thyristor 7 sowie einen zweiten Thyristor 8. Der erste Thyristor 7 ist in den Phasenleiter L derart integriert, daß seine Anode mit dem Anschluss 4 und seine Kathode mit der Verbraucherschaltung 2 verbunden sind. Demgegenüber ist der zweite Thyristor 8 derart mit dem Neutralleiter N gekoppelt, daß seine Anode mit der Verbraucherschaltung 2 und seine Kathode mit dem zweiten Anschluss 5 verbunden sind. Ein Gate-Anschluss 9 des ersten Thyristors 7 ist über einen elektrischen Schalter 10 mit einem Gate-Anschluss 11 des zweiten Thyristors 8 koppelbar. Der elektrische Schalter 10 ist im Ausführungsbeispiel ein Relais und stellt eine Zündeinrichtung der Netzschaltereinrichtung 6 dar. Der Schalter 10 wird mittels einer nicht dargestellten Steuereinheit (etwa Mikrocontroller) angesteuert.

Wird der Schalter 10 geschlossen, so fließt über die Gate-Anschlüsse 9, 11 sowie über den Schalter 10 ein elektrischer Leckstrom (µA), mittels welchem die Thyristoren 7, 8 gezündet und eingeschaltet werden. Dies gilt insbesondere für relativ sensible Thyristoren 7, 8, welche auch mit einem Leckstrom sehr geringer Stromstärke gezündet werden können. Für das Zünden der Thyristoren 7, 8 ist somit nicht erforderlich, daß separate Stromimpulse aktiv erzeugt werden. Ein Schließen des Schalters 10 genügt, um die Thyristoren 7, 8 einzuschalten.

Befindet sich der Schalter 10 in elektrisch leitendem Schaltzustand, so liegt am Eingang der Verbraucherschaltung 2 eine gleichgerichtete Spannung UG an, die beispielsweise von dem genannten Netzteil abgegriffen und mittels des Kondensators geglättet wird. Mit der geglätteten Spannung wird dann der Verbraucher 3 versorgt. Im Betrieb des Verbrauchers 3 verbleibt der Schalter 10 im geschlossenen beziehungsweise elektrisch leitenden Schaltzustand, so daß die Thyristoren 7, 8 fortlaufend ein- und ausgeschaltet werden, nämlich synchron mit der Netzspannung UN.

### Bezugszeichenliste

- 1: Haushaltsgerät
- 2: Verbraucherschaltung
- 3: Verbraucher
- 4: erster Anschluss
- 5: zweiter Anschluss
- 6: Netzschaltereinrichtung
- 7: erster Thyristor
- 8: zweiter Thyristor
- 9: Gate-Anschluss
- 10: Schalter
- 11: Gate-Anschluss
- L: Phasenleiter
- N: Neutralleiter
- UG: gleichgerichtete Spannung
- UN: Netzspannung

## Patentansprüche

1. Haushaltsgerät (1) mit einem ersten und einem zweiten elektrischen Anschluss (4, 5), zwischen denen eine elektrische Netzspannung (UN) anlegbar ist, mit einem elektrischen Verbraucher (3), und mit einer Netzschaltereinrichtung (6), über welche der elektrische Verbraucher (3) mit den Anschlüssen (4, 5) koppelbar ist, wobei die Netzschaltereinrichtung (6) aufweist:
- einen zwischen dem ersten Anschluss (4) und dem elektrischen Verbraucher (3) geschalteten ersten Thyristor (7), dessen Anode mit dem ersten Anschluss (4) und dessen Kathode mit dem elektrischen Verbraucher (3) gekoppelt sind,
- einen zwischen dem zweiten Anschluss (5) und dem elektrischen Verbraucher (3) geschalteten zweiten Thyristor (8), dessen Anode mit dem elektrischen Verbraucher (3) und dessen Kathode mit dem zweiten Anschluss (5) gekoppelt sind, und
- eine Zündeinrichtung (10) zum Zünden der Thyristoren (7, 8), wobei
die Zündeinrichtung (10) einen für die beiden Thyristoren (7, 8) gemeinsamen elektrischen Schalter (10) aufweist, über welchen ein Gate-Anschluss (9) des ersten Thyristors (7) und ein Gate-Anschluss (11) des zweiten Thyristors (8) mit einem elektrischen Zündstrom beaufschlagbar sind
**dadurch gekennzeichnet, daß** Ober den Schalter (10) der Gate-Anschluss (9) des ersten Thyristors (7) mit dem Gate-Anschluss (11) des zweiten Thyristors (8) elektrisch verbindbar ist, so daß in einem elektrisch leitenden Schaltzustand des Schalters (10) die Gate-Anschlüsse (9, 11) elektrisch leitfähig miteinander verbunden sind und hierdurch die Thyristoren (7, 8) mit einem elektrischen Leckstrom als Zündstrom zündbar sind und in einem elektrisch sperrenden Schaltzustand des Schalters (10) die Gate-Anschlüsse (9, 11) elektrisch voneinander getrennt sind.

2. Haushaltsgerät (1) nach Anspruch 1, **dadurch gekennzeichnet, daß** der Schalter (10) ein mechanischer Schalter, insbesondere ein Relais, ist.

3. Verfahren zum Versorgen eines elektrischen Verbrauchers (3) eines Haushaltsgeräts (1) mit elektrischer Energie, wobei der elektrische Verbraucher (3) über eine Netzschaltereinrichtung (6) mit einem ersten und einem zweiten elektrischen Anschluss (4, 5) des Haushaltsgeräts (1) gekoppelt wird, zwischen denen eine elektrische Netzspannung (UN) angelegt wird, wobei der elektrische Verbraucher (3) über einen ersten Thyristor (7) der Netzschaltereinrichtung (6) mit dem ersten Anschluss (4) und über einen zweiten Thyristor (8) der Netzschaftereinrichtung (6) mit dem zweiten Anschluss (5) gekoppelt wird und die Thyristoren (7, 8) mittels einer Zündeinrichtung (10) gezündet werden, wobei ein Gate-Anschluss (9) des ersten Thyristors (7) und ein Gate-Anschluss (11) des zweiten Thyristors (8) über einen gemeinsamen elektrischen Schalter (10) der Zündeinrichtung (10) mit einem elektrischen Zündstrom beaufschlagt werden,
**dadurch gekennzeichnet, daß** Ober den Schalter (10) der Gate-Anschluss (9) des ersten Thyristors (7) mit dem Gate-Anschluss (11) des zweiten Thyristors (8) elektrisch verbunden wird, so daß in einem elektrisch leitenden Schaltzustand des Schalters (10) die Thyristoren (7, 8) mit einem elektrischen Leckstrom als Zündstrom gezündet werden.

## Claims

1. Domestic appliance (1) having a first and a second electrical connection (4, 5), it being possible to apply an electrical supply system voltage (UN) between said electrical connections, having an electrical load (3), and a supply system switch device (6), by means of which the electrical load (3) can be coupled to the connections (4, 5), wherein the supply system switch device (6) comprises:
- a first thyristor (7) which is connected between the first connection (4) and the electrical load (3), and of which the anode is coupled to the first connection (4) and of which the cathode is coupled to the electrical load (3),
- a second thyristor (8) which is connected between the second connection (5) and the electrical load (3), and of which the anode is coupled to the electrical load (3) and of which the cathode is coupled to the second connection (5), and
- a triggering device (10) for triggering the thyristors (7, 8), wherein the triggering device (10) has an electrical switch (10) which is common to both thyristors (7, 8), and by means of which an electrical triggering current can be applied to a gate connection (9) of the first thyristor (7) and a gate connection (11) of the second thyristor (9),
- **characterised in that** the gate connection (9) of the first thyristor (7) can be electrically connected to the gate connection (11) of the second thyristor (8) by way of the switch (10), so that in an electrically conducting switching state of the switch (10), the gate connections (9, 11) are electrically conductively connected to one another and herewith the thyristors (7, 8) can be triggered with an electrical leakage current as a triggering current, and the gate connections (9, 11) are electrically separated from one another in an electrically blocking switching state of the switch (10).

2. Domestic appliance (1) according to claim 1, **characterised in that** the switch (10) is a mechanical switch, in particular a relay.

3. Method for supplying electrical energy to an electrical load (3) of a domestic appliance (1), wherein the electrical load (3) is coupled to a first and a second electrical connection (4, 5) of the domestic appliance (1) by way of a supply system switch device (6), between which electrical connections an electrical supply system voltage (UN) is applied, wherein the electrical load (3) is coupled to the first connection (4) by way of a first thyristor (7) of the power supply switch device (6) and to the second connection (5) by way of a second thyristor (8) of the power supply switch device (6) and the thyristors (7, 8) are triggered by means of a triggering device (10), wherein an electrical triggering current is applied to a gate connection (9) of the first thyristor (7) and a gate connection (11) of the second thyristor (8) by way of a common electrical switch (10) of the triggering device (10),
**characterised in that** the gate connection (9) of the first thyristor (7) is electrically connected to the gate connection (11) of the second thyristor (8) by way of the switch (10) so that that in an electrically conducting switching state of the switch (10), the thyristors (7, 8) are triggered with an electrical leakage current as a triggering current.

## Revendications

1. Appareil ménager (1) comportant un premier et un deuxième raccords électriques (4, 5), entre lesquels une tension électrique de réseau (UN) peut être appliquée, avec un consommateur électrique (3) et avec un dispositif de raccordement au réseau (6), par lequel le consommateur électrique (3) peut être connecté aux raccords (4, 5), dans lequel le dispositif de raccordement au réseau (6) présente:
- un premier thyristor (7) connecté entre le premier raccord (4) et le consommateur électrique (3), dont l'anode est couplée au premier raccord (4) et dont la cathode est couplée au consommateur électrique (3),
- un deuxième thyristor (8) connecté entre le deuxième raccord (5) et le consommateur électrique (3), dont l'anode est couplée au consommateur électrique (3) et dont la cathode est couplée au deuxième raccord (5), et
- un dispositif d'allumage (10) pour l'allumage des thyristors (7, 8),
dans lequel le dispositif d'allumage (10) présente un interrupteur électrique commun (10) pour les deux thyristors (7, 8), par lequel un raccord de grille (9) du premier thyristor (7) et un raccord de grille (11) du deuxième thyristor (8) peuvent être alimentés avec un courant électrique d'allumage,
**caractérisé en ce que** le raccord de grille (9) du premier thyristor (7) peut être relié électriquement au raccord de grille (11) du deuxième thyristor (8) par l'intermédiaire de l'interrupteur (10), de telle manière que, dans un état de commutation électriquement conducteur de l'interrupteur (10), les raccords de grille soient reliés l'un à l'autre de façon électriquement conductrice et que les thyristors (7, 8) puissent ainsi être allumés avec un courant électrique de fuite en tant que courant d'allumage et que, dans un état de commutation électriquement coupé de l'interrupteur (10), les raccords de grille (9, 11) soient électriquement séparés l'un de l'autre.

2. Appareil ménager (1) selon la revendication 1, **caractérisé en ce que** l'interrupteur (10) est un interrupteur mécanique, en particulier un relais.

3. Procédé pour l'alimentation d'un consommateur électrique (3) d'un appareil ménager (1) en énergie électrique, dans lequel le consommateur électrique (3) est couplé par un dispositif de raccordement au réseau (6) à un premier et un deuxième raccords électriques (4, 5) de l'appareil ménager (1), entre lesquels une tension électrique de réseau (UN) peut être appliquée, dans lequel le consommateur électrique (3) est connecté au premier raccord (4) par un premier thyristor (7) du dispositif de raccordement au réseau (6) et au deuxième raccord (5) par un deuxième thyristor (8) du dispositif de raccordement au réseau (6), et les thyristors (7, 8) sont allumés au moyen d'un dispositif d'allumage (10), dans lequel un raccord de grille (9) du premier thyristor (7) et un raccord de grille (11) du deuxième thyristor (8) sont alimentés avec un courant électrique d'allumage par un interrupteur électrique commun (10) du dispositif d'allumage (10), **caractérisé en ce que** le raccord de grille (9) du premier thyristor (7) est électriquement raccordé au raccord de grille (11) du deuxième thyristor (8) par l'interrupteur (10), de telle manière que, dans un état de commutation électriquement conducteur de l'interrupteur (10), les thyristors (7, 8) soient allumés avec un courant électrique de fuite en tant que courant d'allumage.
